(19) **Europäisches Patentamt European Patent Office Office européen des brevets**

(11) **EP 4 723 469 A1**

(12) **EUROPEAN PATENT APPLICATION**

(43) Date of publication:
08.04.2026 Bulletin 2026/15

(21) Application number: 25203003.6

(22) Date of filing: 18.09.2025

(51) International Patent Classification (IPC):
*H02P 8/34* (2006.01)      *G01R 31/34* (2020.01)

(52) Cooperative Patent Classification (CPC):
H02P 8/34; G01R 31/343

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR

(30) Priority: 07.10.2024 US 202418907804

(71) Applicant: STMicroelectronics International N.V.
1228 Plan-les-Ouates, Geneva (CH)

(72) Inventor: LOMBARDI, Prospero
I-20146 Milano (IT)

(74) Representative: Buzzi, Notaro & Antonielli d'Oulx S.p.A.
Corso Vittorio Emanuele II, 6
10123 Torino (IT)

(54) **METHOD FOR MEASURING WINDING ELECTRICAL PARAMETERS IN BIPOLAR STEPPER MOTORS DURING HOLD CONDITION**

(57) Disclosed herein is a method for controlling a stepper motor driver (5) including a control logic (14), a digital-to-analog converter, DAC (15), and two H-bridge circuits for controlling first and second windings (L1, L2) of a bipolar stepper motor (10). The method includes determining desired current signals for the windings (L1, L2) based on a rotational position of the stepper motor (10), converting the desired current signals into analog reference voltages using the DAC (15), generating pre-drive signals based on the analog reference voltages, and controlling the H-bridge circuits using the pre-drive signals to regulate currents through the windings (L1, L2). Voltage drops across sense resistors (RSNSA, RSNSB) are monitored by the control logic (14) as feedback. The desired current signals are determined by generating time-varying periodic current patterns for the windings (L1, L2), the current pattern for the second winding (L2) being phase-shifted relative to the current pattern for the first winding (L1), and both current patterns being dependent on a step frequency of the bipolar stepper motor (10).

**FIG. 1**

EP 4 723 469 A1

**Description**

TECHNICAL FIELD

This disclosure relates generally to the field of electric motor control systems and, more specifically, to stepper motor drivers with integrated diagnostic capabilities. In particular, the invention concerns a method and apparatus for performing in-situ electrical parameter measurements of a bipolar stepper motor during hold conditions, without interrupting normal operation or requiring additional external test equipment.

BACKGROUND

Bipolar stepper motors are widely used in various applications requiring precise position control, such as 3D printers, CNC machines, robotics, and scientific instruments. These motors typically include two orthogonal windings that, when energized with appropriate currents, produce a rotating magnetic field to turn a rotor and drive a motor shaft attached to the rotor. Conventional control methods for bipolar stepper motors involve injecting two sinusoidal currents that are 90 degrees out of phase into the windings. This generates a rotating magnetic flux within the stator, which smoothly rotates the rotor.

The control of bipolar stepper motors often requires knowledge of the motor electrical parameters, such as winding resistance and inductance. These parameters are crucial for implementing effective control strategies, including Proportional-Integral (PI) control loops for winding current. In a PI control loop, the resistance and inductance values are used to tune the proportional and integral gains, ensuring optimal current regulation. Accurate knowledge of these parameters allows for faster response times, reduced overshoot, and improved stability in the current control loop. This, in turn, leads to more precise positioning, smoother motion, and reduced vibration and noise in the motor operation.

Furthermore, knowing the exact winding resistance and inductance enables more accurate torque estimation, which is essential for applications requiring precise force control or for detecting stall conditions. It also allows for more efficient operation by optimizing the applied voltage and minimizing power losses in the motor windings.

However, the electrical parameters provided by motor manufacturers typically have an accuracy of ±20% and may drift over time due to factors such as heating, wear, or environmental conditions. For instance, winding resistance can change significantly with temperature, while inductance may vary with the rotor position and the level of magnetic saturation in the motor core. Relying on these manufacturer-provided data can therefore result in suboptimal control performance, reduced efficiency, and potential positioning errors.

To address this issue, it would be desirable to have a method for precisely measuring the resistance and inductance of the motor windings on the target motor in its actual operating environment, as such measurements would account for the specific characteristics of each individual motor and its current condition.

Attempts at such development have been made. For example, U.S. Pat. No. 10,824,130 (incorporated herein by reference) describes a self-test method that involves energizing the two motor windings with in-phase sinusoidal currents while the motor is in a stalled state. The method drives a first sinusoidal current through one coil and a second, in-phase sinusoidal current through the other coil. Electrical characteristics of the stepper motor are then determined while it is in this stalled state, allowing for system calibration. However, this approach has significant drawbacks that limit its practical application. Firstly, the stall condition is not guaranteed, as the changing polarity of the stator field may cause the rotor to move into alignment with the stator field, potentially disrupting the measurement process. Secondly, this method provides no holding torque. When an external torque is applied to the motor shaft, control is lost as the current magnitude approaches zero during each cycle. This lack of holding torque makes the technique unsuitable for many real-world applications where maintaining a specific position is crucial, particularly in the presence of external forces or loads.

Further development is therefore necessary.

SUMMARY

A method is presented for controlling a stepper motor driver including a control logic unit, a digital-to-analog converter (DAC), and two H-bridge circuits for controlling first and second windings of a bipolar stepper motor. The method involves determining desired current signals for the first and second windings based on a given rotational position of the bipolar stepper motor, converting the desired current signals into analog reference voltages using the DAC, generating pre-drive signals based on the analog reference voltages, controlling the two H-bridge circuits using the pre-drive signals to regulate currents through the first and second windings, and monitoring voltage drops across sense resistors to provide feedback to the control logic unit for adjusting the pre-drive signals. The desired current signals are determined by generating time-varying periodic current patterns for the first and second windings, where the current pattern for the second winding is phase-shifted relative to the current pattern for the first winding, and both current patterns are dependent on a step frequency of the bipolar stepper motor.

The time-varying periodic current patterns may be sinusoidal, with the phase shift between the current pattern for the second winding relative to the current pattern for the first winding being 90°. The current pattern for the first winding may follow the equation $IA = I \cdot \sin(2\pi ft)$, and the current pattern for the second winding may follow the equation IB = I·cos(2πft), where I is peak current amplitude, f is the step frequency, and t is time.

The method may include performing a self-test of the bipolar stepper motor during a hold condition without rotating a motor shaft. The self-test may be performed by the pre-drive signals causing energizing of the first and second windings with current waveforms including both DC and AC components. Electrical parameters of the bipolar stepper motor may be measured based on the energized first and second windings.

The current waveforms for energizing the first and second windings may follow equations: IA = [IDC + IAC sin(2πft)] sin($\alpha$) and IB = [IDC + IAC sin(2πft)] cos($\alpha$), where IDC is a DC current component, IAC is an AC current component, f is a test frequency, t is time, and $\alpha$ is an angular position of a magnetic field. The modulation of IA and IB currents may generate a magnetic flux within the stator with fixed direction and variable magnitude.

Performing the self-test may involve providing inputs to the DAC, the inputs to the DAC being a reference waveform REF = IDC + IAC sin(2πft), sin($\alpha$), and cos($\alpha$), and performing real-time multiplication of the inputs to generate the analog reference voltages.

Alternatively, performing the self-test may involve performing digital multiplication in the control logic unit to generate digital words IA = [IDC + IAC sin(2πft)] sin($\alpha$), and IB = [IDC + IAC sin(2πft)] cos($\alpha$), and providing the digital words IA and IB directly to the DAC to generate the analog reference voltages.

Measuring electrical parameters may involve measuring DC resistance (RDC) of the first and second windings by averaging respective winding voltages and currents over multiple cycles and using Ohm's law for calculating RDC, measuring voltage amplitude, current amplitude, and phase shift of signals in the first and second windings, and calculating AC resistance (RAC) and inductance (L) at a test frequency as per equations: RAC = Z cos($\varphi$) and L = (Z sin($\varphi$)) / (2πf), where Z is impedance magnitude and $\varphi$ is phase shift between voltage and current, and where V/I = Z.

The self-test may be performed periodically during operation of the bipolar stepper motor, applied at a current mechanical position of the bipolar stepper motor during a holding phase. The method may involve selecting which winding or windings to measure based on the current mechanical position and conducting the self-test while maintaining the current mechanical position of the bipolar stepper motor.

Performing the self-test may involve maintaining a holding torque on the bipolar stepper motor using the DC current component (IDC) while measuring the electrical parameters using either the AC current component (IAC) and DC current component (IDC).

The method may involve performing measurement of the first and second windings during the self-test, where when a rotational position ($\alpha$) of the bipolar stepper motor is at 45°, 135°, 225° or 315°, the measurement of the first and second windings is performed with the same performance, and when the rotational position ($\alpha$) approaches 0°, 90°, 180°, or 270°, the measurement is obtained from only one winding at a time, with one winding carrying the full current while the other carries no current.

The method may use pulse width modulation to adjust the pre-drive signals based on the feedback from the sense resistors.

A stepper motor driver for controlling a bipolar stepper motor may include a control logic unit, a digital-to-analog converter (DAC), two H-bridge circuits for controlling first and second windings of the bipolar stepper motor, and sense resistors coupled to the H-bridge circuits. The control logic unit may be configured to perform the method described above.

## BRIEF DESCRIPTION OF THE DRAWINGS

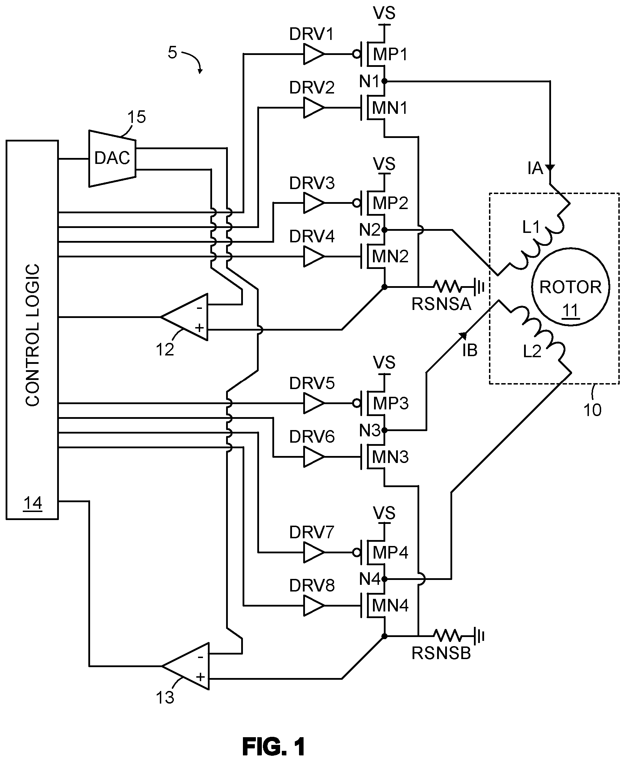

FIG. 1 is a block diagram of a stepper motor driver disclosed herein.

## DETAILED DESCRIPTION

The following disclosure enables a person skilled in the art to make and use the subject matter described herein. The general principles outlined in this disclosure can be applied to embodiments and applications other than those detailed above without departing from the spirit and scope of this disclosure. It is not intended to limit this disclosure to the embodiments shown, but to accord it the widest scope consistent with the principles and features disclosed or suggested herein.

Note that in the following description, any resistor or resistance mentioned is a discrete device, unless stated otherwise, and is not simply an electrical lead between two points. Therefore, any resistor or resistance connected between two points has a higher resistance than a lead between those two points, and such resistor or resistance cannot be interpreted as a lead. Similarly, any capacitor or capacitance mentioned is a discrete device, unless stated otherwise, and is not a parasitic element, unless stated otherwise. Additionally, any inductor or inductance mentioned is a discrete device, unless stated otherwise, and is not a parasitic element, unless stated otherwise.

The stepper motor driver 5 includes a control logic circuit 14 and a digital-to-analog converter (DAC) 15. The driver 5 controls a bipolar stepper motor 10 comprising a rotor 11 and two windings L1 and L2. These windings L1, L2 are orthogonally arranged around the rotor 11 and, when energized with appropriate currents, produce a rotating magnetic field to rotate the rotor 11 and thereby drive a connected motor shaft. The driver incorporates two H-bridge circuits, each controlling one motor winding, to precisely regulate the currents through L1 and L2 and thus control the rotation of the rotor 11.

The first H-bridge circuit includes a first high side transistor (as a non-limiting example, a p-channel transistor MP1), a first low side transistor (as a non-limiting example, n-channel transistor MN1), a second high side transistor (as a non-limiting example p-channel transistor MP2), and a second low side transistor (as a non-limiting example, n-channel transistor MN2). In the specific non-limiting example illustrated: p-channel transistor MP1 has its source coupled to receive the supply voltage VS, its drain connected to node N1, and its gate connected to receive a drive signal from driver DRV1; n-channel transistor MN1 has its drain connected to node N1, its source connected to the first terminal of sense resistor RSNSA, and its gate connected to receive a drive signal from driver DRV2; p-channel transistor MP2 has its source coupled to receive the supply voltage VS, its drain connected to node N2, and its gate connected to receive a drive signal from driver DRV3; and n-channel transistor MN2 has its drain connected to node N2, its source connected to the first terminal of sense resistor RSNSA, and its gate connected to receive a drive signal from driver DRV4.

The second H-bridge circuit includes a first high side transistor (as a non-limiting example, p-channel transistor MP3), a first low side transistor (as a non-limiting example, n-channel transistor MN3), a second high side transistor (as a non-limiting example, p-channel transistor MP4), and a second low side transistor (as a non-limiting example, n-channel transistor MN4). In the specific non-limiting example illustrated: p-channel transistor MP3 has its source coupled to receive the supply voltage VS, its drain connected to node N3, and its gate connected to receive a drive signal from driver DRV5; n-channel transistor MN3 has its drain connected to node N3, its source connected to the first terminal of sense resistor RSNSB, and its gate connected to receive a drive signal from driver DRV6; p-channel transistor MP4 has its source coupled to receive the supply voltage VS, its drain connected to node N4, and its gate connected to receive a drive signal from driver DRV7; and n-channel transistor MN4 has its drain connected to node N4, its source connected to the first terminal of sense resistor RSNSB, and its gate connected to receive a drive signal from driver DRV8.

The second terminals of sense resistors RSNSA and RSNSB are connected to ground. Nodes N1 and N2 are connected to opposite ends of motor winding L1, while nodes N3 and N4 are connected to opposite ends of motor winding L2.

Comparator 12 has its non-inverting input connected to the first terminal of RSNSA and its inverting input connected to receive a reference voltage from DAC 15. Similarly, comparator 13 has its non-inverting input connected to the first terminal of RSNSB and its inverting input connected to receive a reference voltage from DAC 15.

The outputs of comparators 12 and 13 are connected as inputs to the control logic 14. These comparator outputs provide feedback to the control logic about the current levels in windings L1 and L2, respectively. Based on this feedback and the desired motor position, the control logic 14 generates pre-drive signals. These pre-drive signals are sent to the drivers DRV1 through DRV8. Specifically, the control logic 14 provides pre-drive signals to DRV1 and DRV2 for controlling MP1 and MN1, to DRV3 and DRV4 for controlling MP2 and MN2, to DRV5 and DRV6 for controlling MP3 and MN3, and to DRV7 and DRV8 for controlling MP4 and MN4. The drivers then amplify these pre-drive signals to provide the appropriate gate drive voltages to their respective MOSFETs, enabling precise control of the current through each winding L1 and L2 of the stepper motor 10.

During normal operation, the control logic circuit 14 determines the desired current levels for windings L1 and L2 based on the required microstepping position. For smooth rotation, these currents follow sinusoidal patterns that are 90° out of phase. The current through winding L1, denoted as IA, follows the equation $IA = I \cdot \sin(2\pi ft)$, while the current through winding L2, denoted as IB, follows the equation $IB = I \cdot \cos(2\pi ft)$, where I represents the peak current amplitude, f is the electrical frequency, and t is time. This phase relationship between IA and IB creates a rotating magnetic field.

The DAC 15 converts these digital current values for IA and IB into analog reference voltages for the comparators 12 and 13 respectively. The control logic 14 then generates pre-drive signals for the drivers DRV1-DRV8, which in turn control the switching of the MOSFETs in each H-bridge. This switching determines the direction and magnitude of currents IA and IB flowing through windings L1 and L2 respectively, and the control logic 14 generates the pre-drive signals so that the currents IA and IB flowing through windings L1 and L2 are equal to the digital current values for IA and IB.

As currents IA and IB flow through windings L1 and L2, they create a rotating magnetic field that interacts with the rotor 11, causing it to move. The voltage drops across sense resistors RSNSA and RSNSB are continuously monitored by comparators 12 and 13. These comparators provide feedback to the control logic 14, indicating whether the actual winding currents match the desired levels set by the DAC 15. Based on this feedback, the control logic 14 adjusts the pre-drive signals, using pulse width modulation, to regulate the current in each winding precisely.

This closed-loop control allows for accurate microstepping, enabling fine positioning of the rotor 11. The driver continuously modulates the currents in L1 and L2, adjusting their relative magnitudes and directions to achieve the desired rotor position or maintain a specific holding torque. This process repeats continuously, providing smooth and accurate control of the stepper motor 10.

The stepper motor driver 5 incorporates self-test functionality that allows for the measurement of electrical parameters in the bipolar stepper motor 10 during a hold condition, without rotating the motor shaft.

This is achieved by energizing the two windings L1 and L2 with certain specific current waveforms described below.

In particular, the control logic 14 generates digital values representing these current waveforms for each winding L1 and L2. These waveforms follow the equations:

$$IA = [IDC + IAC \cdot \sin(2\pi ft)] \cdot \sin(\alpha)$$

$$IB = [IDC + IAC \cdot \sin(2\pi ft)] \cdot \cos(\alpha)$$

Here, IDC is a DC current component, IAC is an AC current component, *f* is the test frequency, t is time, and $\alpha$ is the angular position of the magnetic field during the hold condition. The modulation of IA and IB currents as described above generates a magnetic flux within the stator with fixed direction and variable magnitude. The DC component IDC provides the holding torque to maintain the position of the rotor 11 during the test. This holding torque is created by a constant magnetic field that keeps the rotor 11 aligned with the magnetic field, preventing unwanted movement during the measurement process.

The control logic 14 provides three inputs to the DAC 15, namely a reference waveform *REF = IDC + IAC · sin(2πft)*, sin($\alpha$), and cos($\alpha$).

The DAC 15 then performs real-time multiplication of these inputs to generate the appropriate analog reference voltages for IA and IB. This allows for control of both the amplitude and phase of the currents in each winding L1 and L2, enabling the self-test functionality.

Another way to obtain the modulated IA and IB currents for the self-test functionality is to perform the multiplication of *IDC + IAC · sin(2πft)* by sin($\alpha$) and *IDC + IAC · sin(2πft)* by cos($\alpha$) in the digital domain inside the control logic and providing the appropriate digital words to the DAC directly.

An example method for obtaining the DC resistance of the windings L1 and L2, the resistance of the windings L1 and L2, and the inductance of the windings L1 and L2 at the selected test frequency is now described. The measurement is performed on each winding independently, with both winding being tested simultaneously.

During the self-test, the control logic 14 modulates the currents by adjusting the digital values sent to the DAC 15. This modulation occurs for an integer number of cycles of the AC component to ensure accurate measurements. The measurement process requires that the control logic 14 gather digital values of the voltage applied from the H-bridge to each motor winding and the current flowing in each motor winding.

The winding currents can be measured directly using a current sensor read by the control logic 14, or estimated using a lookup table that relates the DAC output to the expected current based on known characteristics of the driver and resistors RSNSA and RSNSB.

The voltage applied to the winding can be measured using analog to digital conversion of voltage applied to nodes N1, N2, N3 and N4 or estimated starting from the duty cycle DC applied to each node and the supply voltage VS according to the formula VN = DC*VS.

Various motor parameters can be measured from voltage and current waveforms acquired by the control logic:

The DC resistance (RDC) of each winding L1 and L2 is obtained by averaging both winding voltage and current over multiple complete cycles of the AC component. Since the average value of a sinusoid over a complete cycle is zero, this averaging effectively isolates the DC component, allowing for accurate calculation of RDC using Ohm's law.

The voltage amplitude, current amplitude, and their phase shift are measured from voltage and current waveforms. For example, a peak detection algorithm can be used to obtain voltage and current amplitudes while the time delay of zero crossing instant can be used to derive phase shift.

The AC resistance (RAC) and inductance (L) at the selected test frequency are determined using the equations:

$$V/_I = Z$$

$$RAC = Z \cdot \cos(\varphi)$$

$$L = \frac{Z \cdot \sin(\varphi)}{2\pi f}$$

where Z is the impedance magnitude and $\varphi$ is the phase shift between voltage and current.

This self-test method can be applied at any mechanical position during holding phases, with no movement of the rotor 11 beyond what is programmed for the holding condition. The constant IDC component ensures that the rotor 11 remains stable throughout the test, while the AC component IAC allows for parameter measurement without disrupting the position of the rotor 11.

Note that the effectiveness of the measurement varies with the angular position $\alpha$. When $\alpha$ is 45°, 135°, 225° or 315°, IA equals IB, allowing for measurement of windings L1 and L2 with same performance. However, as $\alpha$ approaches 0°, 90°, 180°, or 270°, the measurement can be obtained from only one winding at a time because at these angles, one of the windings L1 or L2 carries either the full current (sin($\alpha$) or cos($\alpha$) equals 1) while the other carries no current (sin($\alpha$) or cos($\alpha$) equals 0). In these cases, the winding carrying no current cannot be accurately measured, so the test is performed on the active winding.

The control logic 14 can perform this test periodically or on-demand. This provides diagnostic information about the electrical characteristics of the stepper motor 10 without interrupting normal operation, allowing for real-time monitoring of winding parameters across various operating conditions.

This self-test functionality in the stepper motor driver 5 offers several significant advantages. First, it allows for real-time monitoring of motor parameters without interrupting normal operation or requiring the motor to be taken offline. This enables predictive maintenance, as changes in winding resistance or inductance can indicate potential issues before they lead to failure. Second, the ability to perform these measurements during a hold condition means that the test can be conducted frequently without impacting the motor's positioning accuracy or the overall system performance. Third, by utilizing the existing hardware of the stepper motor driver 5, including the control logic 14, DAC 15, and sense resistors RSNSA and RSNSB, this method provides advanced diagnostic capabilities without significantly increasing system cost or complexity. Finally, the flexibility to perform the test at various angular positions allows for a comprehensive understanding of the motor's characteristics under different load conditions. Together, these advantages make this self-test method suited for improving the reliability, efficiency, and longevity of stepper motor-driven systems across a wide range of applications.

Finally, it is evident that modifications and variations can be made to what has been described and illustrated herein without departing from the scope of this disclosure.

Although this disclosure has been described with a limited number of embodiments, those skilled in the art, having the benefit of this disclosure, can envision other embodiments that do not deviate from the disclosed scope. Furthermore, skilled persons can envision embodiments that represent various combinations of the embodiments disclosed herein made in various ways.

**Claims**

1. A method for controlling a stepper motor driver (5) including a control logic unit (14), a digital-to-analog converter, DAC (15), and two H-bridge circuits for controlling first and second windings (L1, L2) of a bipolar stepper motor (10), the method comprising:

   determining desired current signals for the first and second windings (L1, L2) based on a given rotational position of the bipolar stepper motor (10);
   converting the desired current signals into analog reference voltages using the DAC (15);
   generating pre-drive signals based on the analog reference voltages; controlling the two H-bridge circuits using the pre-drive signals to regulate currents through the first and second windings (L1, L2); and
   monitoring voltage drops across sense resistors (RSNSA, RSNSB) to provide feedback to the control logic unit (14) for adjusting the pre-drive signals;
   wherein the desired current signals are determined by generating time-varying periodic current patterns for the first and second windings (L1, L2), wherein the current pattern for the second winding (L2) is phase-shifted relative to the current pattern for the first winding (L1), and wherein both current patterns are dependent on a step frequency of the bipolar stepper motor (10).

2. The method of claim 1, wherein the time-varying periodic current patterns are sinusoidal, the phase shift between the current pattern for the second winding (L2) relative to the current pattern for the first winding (L1) is 90°, the current pattern for the first winding (L1) follows the equation $IA = I \cdot \sin(2\pi ft)$, and the current pattern for the second winding (L2) follows the equation $IB = I \cdot \cos(2\pi ft)$, where I is peak current amplitude, f is the step frequency, and t is time.

3. The method of claim 1, further comprising: performing a self-test of the bipolar stepper motor (10) during a hold condition without rotating a motor shaft, the self-test being performed by the pre-drive signals causing energizing of the first and second windings (L1, L2) with current waveforms comprising both DC and AC components; and measuring electrical parameters of the bipolar stepper motor (10) based on the energized first and second windings (L1, L2).

4. The method of claim 3, wherein: the current waveforms for energizing the first and second windings (L1, L2) follow equations: $IA = [IDC + IAC \sin(2\pi ft)] \sin(\alpha)$ and $IB = [IDC + IAC \sin(2\pi ft)] \cos(\alpha)$ where: IDC is a DC current component, IAC is an AC current component, f is a test frequency, t is time, and $\alpha$ is an angular position of a magnetic field; and wherein the modulation of IA and IB currents generates a magnetic flux within the stator with fixed direction and variable magnitude.

5. The method of claim 3, wherein performing the self-test further comprises: providing inputs to the DAC (15), the inputs to the DAC (15) being a reference waveform $REF = IDC + IAC \sin(2\pi ft)$, $\sin(\alpha)$, and $\cos(\alpha)$; and performing real-time multiplication of the inputs to thereby generate the analog reference voltages.

6. The method of claim 3, wherein performing the self-test further comprises:

performing digital multiplication in the control logic unit (14) to generate digital words IA = [IDC + IAC sin(2πft)] sin(α), and IB = [IDC + IAC sin(2πft)] cos(α); and

providing the digital words IA and IB directly to the DAC (15) to generate the analog reference voltages.

7. The method of claim 3, wherein measuring electrical parameters comprises:

measuring DC resistance (RDC) of the first and second windings (L1, L2) by averaging respective winding voltages and currents over multiple cycles;

measuring voltage amplitude, current amplitude, and phase shift of signals in the first and second windings (L1, L2); and

calculating AC resistance (RAC) and inductance (L) at a test frequency as per equations:

$$RAC = Z \cos(\varphi)$$

$$L = (Z \sin(\varphi)) / (2\pi f)$$

where Z is impedance magnitude and φ is phase shift between voltage and current, and where V/I = Z.

8. The method of claim 3, further comprising:

performing the self-test periodically during operation of the bipolar stepper motor (10);

applying the self-test at a current mechanical position of the bipolar stepper motor (10) during a holding phase;

selecting which winding or windings (L1, L2) to measure based on the current mechanical position; and

conducting the self-test while maintaining the current mechanical position of the bipolar stepper motor (10).

9. The method of claim 3, wherein performing the self-test comprises: maintaining a holding torque on the bipolar stepper motor (10) using the DC current component (IDC) while measuring the electrical parameters using either the AC current component (IAC) and DC current component (IDC).

10. The method of claim 3, further comprising: performing measurement of the first and second windings (L1, L2) during the self-test, wherein:

when a rotational position (α) of the bipolar stepper motor (10) is at 45°, 135°, 225° or 315°, the measurement of the first and second windings (L1, L2) is performed with the same performance; and

when the rotational position (α) approaches 0°, 90°, 180°, or 270°, the measurement is obtained from only one winding (L1 or L2) at a time, with one winding carrying the full current while the other carries no current.

11. The method of claim 1, further comprising using pulse width modulation to adjust the pre-drive signals based on the feedback from the sense resistors (RSNSA, RSNSB).

12. A stepper motor driver (5) for controlling a bipolar stepper motor (10), the stepper motor driver (5) comprising:

a control logic unit (14); a digital-to-analog converter (DAC) (15);

two H-bridge circuits for controlling first and second windings (L1, L2) of the bipolar stepper motor (10);

sense resistors (RSNSA, RSNSB) coupled to the H-bridge circuits; and

wherein the control logic unit (14) is configured to perform the method of any of claims 1 to 11.

**FIG. 1**

**EUROPEAN SEARCH REPORT**

Application Number

EP 25 20 3003

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 824 130 B2 (TEXAS INSTRUMENTS INC [US]) 3 November 2020 (2020-11-03) | 1-7,11, 12 | INV. H02P8/34 |
| Y | * the whole document * | 8,9 | G01R31/34 |
| A | | 10 | |
| | ----- | | |
| A | US 2008/309274 A1 (THOMSON BARRY [CA]) 18 December 2008 (2008-12-18) * the whole document * | 1-12 | |
| | ----- | | |
| Y | ODHANO SHAFIQ AHMED ET AL: "Identification of the Magnetic Model of Permanent-Magnet Synchronous Machines Using DC-Biased Low-Frequency AC Signal Injection", IEEE TRANSACTIONS ON INDUSTRY APPLICATIONS, IEEE SERVICE CENTER, PISCATAWAY, NJ, US, vol. 51, no. 4, 1 July 2015 (2015-07-01), pages 3208-3215, XP011663223, ISSN: 0093-9994, DOI: 10.1109/TIA.2015.2413383 [retrieved on 2015-07-15] | 8,9 | |
| A | * the whole document * | 1-7, 10-12 | TECHNICAL FIELDS SEARCHED (IPC) H02P G01R |
| | ----- | | |
| A | ODHANO SHAFIQ AHMED ET AL: "Parameter Identification and Self-Commissioning in AC Motor Drives: A Technology Status Review", IEEE TRANSACTIONS ON POWER ELECTRONICS, INSTITUTE OF ELECTRICAL AND ELECTRONICS ENGINEERS, USA, vol. 34, no. 4, 1 April 2019 (2019-04-01), pages 3603-3614, XP011714173, ISSN: 0885-8993, DOI: 10.1109/TPEL.2018.2856589 [retrieved on 2019-03-08] * the whole document * | 1-12 | |
| | ----- | | |
| | -/-- | | |

The present search report has been drawn up for all claims

| Place of search | Date of completion of the search | Examiner |
|---|---|---|
| Munich | 11 February 2026 | Koteich, Mohamad |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 25 20 3003

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Ostermann Thorsten:  "Assembly Information Stepper Motor Card HP-Step", , 27 December 2005 (2005-12-27), pages 1-4, XP093365302, www.NC-Step.de Retrieved from the Internet: URL:www.mechapro.de/pdf/hpstep_15b_en.pdf * the whole document * ----- | 1 | |

| | | | TECHNICAL FIELDS SEARCHED (IPC) |
|---|---|---|---|

The present search report has been drawn up for all claims

| Place of search | Date of completion of the search | Examiner |
|---|---|---|
| Munich | 11 February 2026 | Koteich, Mohamad |

EPO FORM 1503 03.82 (P04C01)

## ANNEX TO THE EUROPEAN SEARCH REPORT
## ON EUROPEAN PATENT APPLICATION NO.

EP 25 20 3003

This annex lists the patent family members relating to the patent documents cited in the above-mentioned European search report.
The members are as contained in the European Patent Office EDP file on
The European Patent Office is in no way liable for these particulars which are merely given for the purpose of information.

11-02-2026

| Patent document cited in search report | Publication date | Patent family member(s) | Publication date |
|---|---|---|---|
| US 10824130 B2 | 03-11-2020 | US 2020249648 A1 <br> US 2021011451 A1 | 06-08-2020 <br> 14-01-2021 |
| US 2008309274 A1 | 18-12-2008 | NONE | |

EPO FORM P0459

For more details about this annex : see Official Journal of the European Patent Office, No. 12/82

**REFERENCES CITED IN THE DESCRIPTION**

**Patent documents cited in the description**

- US 10824130 B